# EUROPÄISCHE PATENTANMELDUNG

(11) **EP 4 485 958 A1**
(43) Veröffentlichungstag der Anmeldung: **01.01.2025**
(21) Anmeldenummer: 24179575.6
(22) Anmeldetag: 03.06.2024
(51) Int. Cl.: H04N 23/71, H04N 23/76, H04N 23/81

(54) **VERFAHREN ZUM AUFZEICHNEN VON BILDDATEN**

(30) Priorität: 30.06.2023 DE 102023117310
(71) Anmelder: Arnold & Richter Cine Technik GmbH & Co. Betriebs KG, 80807 München (DE)
(72) Erfinder: BRENDEL, Harald, 80336 München (DE)
(74) Vertreter: Manitz Finsterwald Patent- und Rechtsanwaltspartnerschaft mbB

(57) **Zusammenfassung**

Es wird ein Verfahren zum Aufzeichnen von Bilddaten mittels einer Kamera, insbesondere mittels einer Bewegtbildkamera, bereitgestellt. Dabei umfasst die Kamera einen Bildsensor mit verstellbarer Empfindlichkeit, der eine Vielzahl von in Zeilen und Spalten angeordneten lichtempfindlichen Detektorelementen umfasst und dazu ausgebildet ist, in Abhängigkeit von der Intensität von Licht, das während einer jeweiligen Einzelbelichtung auf ein jeweiliges Detektorelement auftrifft, eine jeweilige elektrische Ladung zu erzeugen und sie in Abhängigkeit von der eingestellten Empfindlichkeit zu verstärken und in einen jeweiligen Bildsignalwert umzuwandeln. Das Verfahren umfasst: dass eine Aufnahmeempfindlichkeit und eine Zielempfindlichkeit vorgegeben werden, wobei die Aufnahmeempfindlichkeit um einen Belichtungskorrekturwert von der Zielempfindlichkeit abweicht; dass mittels der Kamera Bilddaten aufgezeichnet werden, während die Empfindlichkeit des Bildsensors auf die Aufnahmeempfindlichkeit eingestellt ist; dass in Abhängigkeit von der Zielempfindlichkeit und/oder dem Belichtungskorrekturwert eine Rauschkorrektur ermittelt wird; und dass korrigierte Bilddaten erzeugt werden, indem die aufgezeichneten Bilddaten anhand der Rauschkorrektur modifiziert werden.

## Beschreibung

Die Erfindung betrifft ein Verfahren zum Aufzeichnen von Bilddaten mittels einer Kamera, insbesondere mittels einer Bewegtbildkamera.

Mittels einer Kamera lassen sich als Bilddaten ein oder mehrere Einzelbilder einer jeweiligen Szene aufzeichnen, indem Licht, das von Objekten der Szene ausgeht (abgestrahlt oder reflektiert wird), von einer Optik der Kamera auf einen Bildsensor der Kamera gelenkt wird, so dass die Szene auf den Bildsensor abgebildet wird. Der Bildsensor umfasst dabei in der Regel eine Vielzahl von in Zeilen und Spalten angeordneten lichtempfindlichen Detektorelementen, die jeweils dazu ausgebildet sind, in Abhängigkeit von der Intensität des auf das jeweilige Detektorelement auftreffenden Lichts eine jeweilige elektrische Ladung zu erzeugen und sie in einen jeweiligen Bildsignalwert umzuwandeln. Auf diese Weise kann während einer jeweiligen Einzelbelichtung - d. h. während eines einzelnen Belichtungsvorgangs, bei dem auf die Detektorelemente im Wesentlichen zeitgleich für eine bestimmte Zeitdauer (Verschlusszeit) Licht der Szene auftrifft - für jedes Detektorelement ein jeweiliger Bildsignalwert erzeugt werden. Die infolge einer jeweiligen Einzelbelichtung erzeugten Bildsignalwerte bilden dann gemeinsam ein jeweiliges Einzelbild.

Mittels eines jeweiligen Detektorelements lässt sich dabei nur Licht, dessen Intensität innerhalb eines bestimmten Intensitätsbereichs liegt, sinnvoll in einen jeweiligen Bildsignalwert umwandeln, so dass der jeweilige Bildsignalwert tatsächlich aussagekräftig für die jeweilige Intensität des Lichts ist. Denn wenn die Intensität zu hoch ist (Überbelichtung), gerät das Detektorelement in eine Sättigung, so dass verschiedene zu hohe Intensitäten nicht unterschieden werden können, da sie zu demselben (maximalen) Bildsignalwert führen; wenn die Intensität dagegen zu niedrig ist (Unterbelichtung), wird das Umwandeln des auftreffenden Lichts in einen jeweiligen Bildsignalwert von einem grundsätzlich nicht vermeidbaren Rauschen des Bildsensors dominiert, so dass verschiedene zu niedrige Intensitäten nicht unterschieden werden können, da sie im Rauschen untergehen. Das Rauschen kann dabei einerseits Anteile eines elektronischen Rauschens verschiedener elektronischer Komponenten des jeweiligen Detektorelements bzw. des Bildsensors und andererseits Anteile eines durch die Quanten-Natur des Lichts bedingten Rauschens (zum Beispiel Schrotrauschen) umfassen. Der genannte Intensitätsbereich, für den aussagekräftige Bildsignalwerte erzeugt werden können, ist daher beschränkt und definiert einen Dynamikumfang des Bildsensors.

Beim Aufzeichnen von Bilddaten wird in der Regel angestrebt, dass möglichst für jedes Detektorelement das darauf auftreffende Licht eine Intensität innerhalb des genannten Intensitätsbereichs aufweist. Idealerweise befindet sich die Intensität des Lichts dabei insgesamt zumindest weitgehend in einem mittleren Bereich des Intensitätsbereichs, so dass das resultierende Bild eine mittlere Helligkeit aufweist und von Schatten bis zu Glanzlichtern der Szene insgesamt ein großer Bereich des Dynamikumfangs des Bildsensors ausgenutzt werden kann. Je nach künstlerischer Gestaltungsabsicht kann aber auch gezielt eine andere Helligkeitsverteilung angestrebt werden.

Die Intensität des auf ein jeweiliges Detektorelement auftreffenden Lichts hängt zum einen von der Helligkeit des jeweiligen Objekts der Szene ab, von dem das Licht ausgeht, wobei diese Helligkeit durch eine, insbesondere künstliche, Beleuchtung der Szene beeinflusst werden kann. Zum anderen kann die Intensität des auftreffenden Lichts von verschiedenen weiteren Parametern abhängen, nämlich insbesondere von der in der Regel verstellbaren Apertur einer Blende der Kamera sowie der in der Regel verstellbaren Verschlusszeit eines Verschlusses der Kamera. Denn durch die Blende wird in Abhängigkeit von der jeweils eingestellten Apertur der Querschnitt des einfallenden Strahlenbündels idealerweise im Bereich der Hauptebene der Kameraoptik beschränkt und dadurch auf räumliche Weise die Menge an Licht, die während einer jeweiligen Einzelbelichtung auf den Bildsensor trifft, beeinflusst; durch den Verschluss, bei dem es sich um einen mechanischen oder um einen elektronischen (etwa durch entsprechende Ansteuerung des Bildsensors realisierten) Verschluss handeln kann, wird in Abhängigkeit von der jeweils eingestellten Verschlusszeit die Dauer der jeweiligen Einzelbelichtung beschränkt und dadurch auf zeitliche Weise die Menge an Licht, die während einer jeweiligen Einzelbelichtung auf den Bildsensor trifft, beeinflusst.

Einen weiteren Einfluss auf die Bildhelligkeit hat ferner die Empfindlichkeit des Bildsensors, die vorzugsweise verstellbar ist und in der Regel als sogenannter ISO-Wert vorgegeben wird. Die ISO-Einstellung verändert jedoch nicht in die Menge des auf den Bildsensor auftreffenden Lichts, sondern die Weise, in der dieses Licht über eine jeweilige erzeugte elektrische Ladung in einen jeweiligen Bildsignalwert umgewandelt wird, insbesondere wie sehr die elektrische Ladung dabei verstärkt wird. Dabei kann auch diese Verstärkung in eine Sättigung laufen und verursacht außerdem ein von dem Maß der Verstärkung abhängiges Rauschen.

Insbesondere bei Bewegtbildaufnahmen kann es vorkommen, dass in mehreren Abschnitten nacheinander inhaltlich zusammenhängende Bilddaten aufgezeichnet werden und sich die Belichtungsverhältnisse, die Einfluss auf die Menge an Licht, die auf den Bildsensor auftrifft, haben und sich insbesondere (zumindest unter anderem) aus der Helligkeit bzw. Beleuchtung der aufgezeichneten Szene, der eingestellten Apertur der Blende und/oder der eingestellten Verschlusszeit des Verschlusses der Kamera ergeben, zwischendurch verändern. Eine solche Änderung in den Belichtungsverhältnissen kann sich aus Gründen ergeben, die nicht oder nur schwer beeinflusst werden können, beispielsweise wenn sie durch Schwankungen des Tageslichts verursacht wird. Die Änderung der Belichtungsverhältnisse kann aber auch ein Nebeneffekt eines beabsichtigten Verstellens sein, beispielweise wenn aus kreativen Gründen, etwa zum Ändern der Schärfentiefe, die Apertur der Blende verstellt wird.

Es kann daher erforderlich sein, eine Änderung in den Belichtungsverhältnissen auszugleichen, damit bei unterschiedlichen Belichtungsverhältnissen aufgezeichnete Bilddaten hinsichtlich ihrer jeweiligen Helligkeit zueinander passen. Ein solcher Ausgleich kann beispielsweise durch ND-Filter (Neutraldichtefilter, *neutral density filter*) erzielt werden, die einen definierten Anteil des Lichts ausfiltern. In der Regel wird dieser Anteil als optische Dichte des ND-Filters angegeben. Beispielsweise entspricht eine optische Dichte von 0.3 (genauer: log₁₀ 2) einer Reduktion der Lichtintensität um eine Blendenstufe, was seinerseits einer Halbierung der Lichtmenge entspricht. Derartige ND-Filter können vor einem Objektiv der Kamera und/oder in der Kamera zwischen dem Objektiv und dem Bildsensor angebracht werden. Das Anbringen eines oder mehrerer ND-Filter vor dem Objektiv kann jedoch die Arbeit am Set der jeweiligen Aufzeichnung verzögern. Außerdem können vor dem Objektiv angebrachte ND-Filter zu störenden Reflexen führen. In der Kamera vorgesehene ND-Filter erhöhen den konstruktiven Aufwand der Kamera. Es ist daher grundsätzlich vorteilhaft, wenn ND-Filter vermieden werden können.

Qualitativ besonders hochwertige Kameras weisen mittlerweile einen großen Dynamikumfang auf, der es grundsätzlich (zumindest in gewissem Rahmen) zulässt, dass eine Änderung in den Belichtungsverhältnissen nicht zwingend durch eine Veränderung der auftreffenden Lichtmenge, etwa durch die Verwendung von ND-Filtern, ausgeglichen werden muss, solange die Änderung die Helligkeit nur so weit verschiebt, dass auch die hellsten Bereiche noch nicht in die Sättigung laufen bzw. auch die dunkelsten Bereiche noch nicht im Rauschen untergehen. Die Bilddaten können bei hinreichendem Dynamikumfang also grundsätzlich ohne besondere Anpassung an die veränderten Belichtungsverhältnisse aufgezeichnet werden, sind dann jedoch entsprechend heller oder dunkler.

Die veränderte Helligkeit lässt sich grundsätzlich durch ein entsprechendes Verstellen der Empfindlichkeit des Bildsensors an die bei den ursprünglichen Verhältnissen aufgezeichneten Bilddaten anpassen. Allerdings weisen die mit veränderter Empfindlichkeit aufgezeichneten Bilddaten im Vergleich zu den bei den ursprünglichen Bildverhältnissen aufgezeichneten Bilddaten infolge der veränderten Belichtungsverhältnisse in Relation zur jeweiligen Empfindlichkeit des Bildsensors aus prinzipiellen Gründen (aufgrund der Quanten-Natur des Lichts) ein anderes Rauschen (Signal-Rausch-Verhältnis) auf. Nacheinander bei unterschiedlichen Belichtungsverhältnissen aufgezeichnete Bilddaten können dann aufgrund des unterschiedlichen Rauschens einen wahrnehmbar unterschiedlichen Charakter aufweisen. Insbesondere im Kontext qualitativ hochwertiger Bewegtbildaufnahmen, wie etwa für Kinoproduktionen, können derartige unbeabsichtigte Unterschiede im Bildrauschen inakzeptabel sein.

Es ist eine Aufgabe der Erfindung, ein Verfahren zum Aufzeichnen von Bilddaten mittels einer Kamera, insbesondere mittels einer Bewegtbildkamera, bereitzustellen, das einen einfachen Ausgleich einer Veränderung in den Belichtungsverhältnissen ermöglicht und dabei die Nachteile des Stands der Technik vermeidet, insbesondere keine ND-Filter voraussetzt und nicht zu wahrnehmbaren Veränderungen des Bildrauschens führt.

Die Aufgabe wird gelöst durch ein Verfahren mit den Merkmalen des Anspruchs 1. Vorteilhafte Ausführungsformen ergeben sich aus den abhängigen Ansprüchen, der vorliegenden Beschreibung sowie den Figuren.

Das erfindungsgemäße Verfahren dient dem Aufzeichnen von Bilddaten mittels einer Kamera, insbesondere mittels einer Bewegtbildkamera. Bei den Bilddaten kann es sich um Stillbilddaten in Form eines Einzelbildes oder um Bewegtbilddaten in Form einer Abfolge von Einzelbildern handeln, wobei die Einzelbilder der Abfolge vorzugsweise bei konstanter Bildrate aufgezeichnet sind bzw. werden. Die Kamera umfasst dabei einen Bildsensor mit verstellbarer Empfindlichkeit, der eine Vielzahl von in Zeilen und Spalten angeordneten lichtempfindlichen Detektorelementen umfasst und dazu ausgebildet ist, in Abhängigkeit von der Intensität von Licht, das während einer jeweiligen Einzelbelichtung auf ein jeweiliges Detektorelement auftrifft, eine jeweilige elektrische Ladung zu erzeugen und sie in Abhängigkeit von der eingestellten Empfindlichkeit zu verstärken und in einen jeweiligen Bildsignalwert umzuwandeln.

Die auf diese Weise während einer jeweiligen Einzelbelichtung gewonnenen Bildsignalwerte bilden dann gemeinsam Bilddaten eines jeweiligen Einzelbilds. Mit anderen Worten: Ein jeweiliges Einzelbild entspricht einem Datensatz von Bildsignalwerten, die aufgrund einer jeweilige Einzelbelichtung (d. h. eines definierten Zeitraums, in dem fortlaufend Licht der aufzuzeichnenden Szene auf den Bildsensor trifft und zur Erzeugung elektrischer Ladungen führt) erzeugt werden.

Die Kamera kann ferner eine Blende mit verstellbarer Apertur umfassen, die dazu ausgebildet ist, in Abhängigkeit von der eingestellten Apertur die Menge an Licht, die während der jeweiligen Einzelbelichtung auf den Bildsensor trifft, zu reduzieren - etwa durch Beschränkung des Querschnitts des einfallenden Strahlenbündels, idealerweise im Bereich der Hauptebene einer Kameraoptik. Des Weiteren kann die Kamera einen (mechanischen oder elektronischen) Verschluss mit verstellbarer Verschlusszeit umfassen, der dazu ausgebildet ist, die Dauer der jeweiligen Einzelbelichtung, während deren Licht auf den Bildsensor trifft, auf die eingestellte Verschlusszeit zu begrenzen. Ein solcher Verschluss kann beispielsweise in Form einer rotierenden Sektorenblende (auch als Umlaufblende bezeichnet) ausgebildet sein, deren Drehzahl und/oder Hellsektorgröße verstellbar ist/sind.

Erfindungsgemäß umfasst das Verfahren: dass eine Aufnahmeempfindlichkeit und eine Zielempfindlichkeit vorgegeben werden, wobei die Aufnahmeempfindlichkeit um einen Belichtungskorrekturwert von der Zielempfindlichkeit abweicht; dass mittels der Kamera Bilddaten aufgezeichnet werden, während die Empfindlichkeit des Bildsensors auf die Aufnahmeempfindlichkeit eingestellt ist; dass in Abhängigkeit von der Zielempfindlichkeit und/oder dem Belichtungskorrekturwert eine Rauschkorrektur ermittelt wird; und dass korrigierte Bilddaten erzeugt werden, indem die aufgezeichneten Bilddaten anhand der Rauschkorrektur modifiziert werden. Anschließend können die korrigierten Bilddaten von der Kamera ausgegeben werden.

Die Aufnahmeempfindlichkeit und die Zielempfindlichkeit können jeweils insbesondere in Form eines sogenannten ISO-Werts angegeben werden, der im Wesentlichen der ISO-Empfindlichkeit eines fotografischen Films entspricht. Für das Aufzeichnen der Bilddaten wird der Bildsensor auf die Aufnahmeempfindlichkeit eingestellt. Insofern handelt es sich bei der Aufnahmeempfindlichkeit um eine tatsächlich eingestellte Empfindlichkeit des Bildsensors. Dagegen kann die Zielempfindlichkeit eine lediglich nominelle Empfindlichkeit darstellen, nämlich insofern, als durch die Zielempfindlichkeit vorgegeben werden kann, dass die korrigierten Bilddaten letztlich so erscheinen sollen, als seien sie mittels eines auf die Zielempfindlichkeit eingestellten Bildsensors aufgezeichnet worden.

Der Belichtungskorrekturwert ist vorzugsweise ungleich null und kann insbesondere in Blendenstufen angegeben werden. Eine Blendenstufe entspricht dabei einer Änderung der Empfindlichkeit derart, dass je nach Vorzeichen des Belichtungskorrekturwerts durch die Änderung der Empfindlichkeit eine Verdopplung oder Halbierung der Menge an auf den Bildsensor auftreffendem Licht ausgeglichen wird. In welche Richtung die Korrektur bei welchem Vorzeichen erfolgt, ist dabei Definitionssache. Im vorliegenden Kontext soll eine Veränderung der Empfindlichkeit des Bildsensors um einen negativen Belichtungskorrekturwert bedeuten, dass sich die Empfindlichkeit verringert, der ISO-Wert also abnimmt. Bei einem negativen Belichtungskorrekturwert ist die Aufnahmeempfindlichkeit also kleiner als die Zielempfindlichkeit.

Das Vorgeben der Aufnahmeempfindlichkeit und der Zielempfindlichkeit kann durch einen Nutzer der Kamera erfolgen, beispielsweise mittels einer Eingabevorrichtung der Kamera. Die Aufnahmeempfindlichkeit und die Zielempfindlichkeit brauchen nicht unbedingt beide direkt vorgegeben zu werden, denn es können stattdessen nur eine dieser Empfindlichkeiten und anstelle der anderen der Belichtungskorrekturwert direkt vorgegeben werden, wodurch die andere indirekt ebenfalls vorgegeben wird, da sie sich aus der einen Empfindlichkeit und dem Belichtungskorrekturwert eindeutig ableiten lässt. Insbesondere kann vorgesehen sein, dass die Zielempfindlichkeit und der Belichtungskorrekturwert direkt vorgegeben werden, wobei sich die Aufnahmeempfindlichkeit dann aus der Zielempfindlichkeit und dem Belichtungskorrekturwert bestimmen lässt und somit indirekt vorgegeben wird. Beispielsweise kann als Zielempfindlichkeit ein Wert von ISO 800 und als Belichtungskorrekturwert ein Wert von -1 Blendenstufe vorgegeben werden, wodurch indirekt eine Aufnahmeempfindlichkeit von ISO 400 vorgegeben wird.

In Abhängigkeit von der Zielempfindlichkeit und/oder dem Belichtungskorrekturwert wird die genannte Rauschkorrektur ermittelt. Vorzugsweise wird die Rauschkorrektur in Abhängigkeit sowohl von der Zielempfindlichkeit als auch von dem Belichtungskorrekturwert ermittelt. Dabei müssen die Zielempfindlichkeit und der Belichtungskorrekturwert wiederum für das Ermitteln der Rauschkorrektur nicht unbedingt direkt herangezogen werden, sondern einer dieser Werte kann sich auch indirekt aus dem jeweils anderen in Verbindung mit der Aufnahmeempfindlichkeit ergeben. Insofern kann die Rauschkorrektur auch in (direkter oder indirekter) Abhängigkeit von der Aufnahmeempfindlichkeit ermittelt werden.

Die Rauschkorrektur dient dazu, die Unterschiede zwischen dem Rauschen, das ein mittels des auf die Aufnahmeempfindlichkeit eingestellten Bildsensors aufgezeichnetes Einzelbild tatsächlich aufweist, und dem Rauschen, das für ein mittels des auf die Zielempfindlichkeit eingestellten Bildsensors aufgezeichnetes Einzelbild zu erwarten wäre, auszugleichen. Grundsätzlich kommen verschiedene Weisen in Betracht, eine solche Rauschkorrektur in Abhängigkeit von der Zielempfindlichkeit und/oder dem Belichtungskorrekturwert (bzw. der Aufnahmeempfindlichkeit) zu ermitteln. Beispielsweise kann die Rauschkorrektur auf Empirie beruhen, indem anhand von Bilddaten, die bei verschiedenen Empfindlichkeiten des Bildsensors aufgezeichnet worden sind, verglichen wird, wie sich das Rauschen bei verschiedenen Empfindlichkeiten unterscheidet, wobei die Rauschkorrektur dann in Abhängigkeit von diesem Unterschied ermittelt werden kann. Alternativ oder zusätzlich dazu kann für das Ermitteln der Rauschkorrektur auch ein theoretisches Modell des Rauschens herangezogen werden. Die empirischen Daten ebenso wie das theoretische Modell können dabei allgemeiner Art und somit für verschiedene Bildsensoren (eines bestimmten Typs) gültig sein oder aber für den jeweiligen Bildsensor spezifisch ermittelt bzw. definiert sein.

Anhand der ermittelten Rauschkorrektur werden schließlich die aufgezeichneten Bilddaten modifiziert und auf diese Weise korrigierte Bilddaten erzeugt. Dass die korrigierten Bilddaten erzeugt werden, indem die aufgezeichneten Bilddaten anhand der Rauschkorrektur modifiziert werden, soll dabei nicht ausschließen, dass das Erzeugen der korrigierten Bilddaten noch weitere Schritte, insbesondere weitere Modifikationen der aufgezeichneten Bilddaten, umfasst.

Beispielweise kann das Erzeugen der korrigierten Bilddaten außerdem umfassen, dass die Helligkeit der aufgezeichneten Bilddaten modifiziert wird, um verbleibende Helligkeitsabweichungen auszugleichen. Die aufgezeichneten Bilddaten werden dabei vorzugsweise in Abhängigkeit von dem Belichtungskorrekturwert hinsichtlich ihrer Helligkeit modifiziert. Dieses Modifizieren kann ein Multiplizieren der aufgezeichneten Bilddaten, insbesondere der Bildsignalwerte, mit einem von dem Belichtungskorrekturwert (insbesondere exponentiell) abhängigen Belichtungskorrekturfaktor umfassen, wobei dieser Belichtungskorrekturfaktor zusätzlich von dem jeweiligen Bildsignalwert abhängen kann. Falls eine Gammakorrektur auf den Bildsignalwert angewandt worden ist, kann ferner vorgesehen sein, dass der Bildsignalwert zunächst wieder linearisiert wird (inverse Gammakorrektur), bevor er mit dem Belichtungskorrekturfaktor multipliziert wird, und anschließend wieder die Gammakorrektur angewandt wird.

Aufgrund des erfindungsgemäßen Verfahrens können die korrigierten Bilddaten dann hinsichtlich ihrer Helligkeit und ihres Rauschens mit anderen Bilddaten, die vor einer Änderung der Belichtungsverhältnisse aufgezeichnet worden sind, gleichwohl weitgehend übereinstimmen, ohne dass dazu die Verwendung von ND-Filtern erforderlich wäre. So können der Aufwand und die Schwierigkeiten, die eine Verwendung von ND-Filtern üblicherweise mit sich bringt, auf einfache Weise vermieden werden.

Der Begriff "Bildsensor mit verstellbarer Empfindlichkeit" ist im vorliegenden Zusammenhang breit zu verstehen und umfasst nicht nur die eigentlichen lichtempfindlichen Detektorelemente (beispielsweise in CMOS-Technologie), sondern auch eine integrierte oder zugeordnete Verstärkungselektronik (beispielsweise Spaltenverstärker für die Spalten von lichtempfindlichen Detektorelementen, wie zum Beispiel aus DE 102013209164 B4 bekannt).

Gemäß einer vorteilhaften Ausführungsform ist vorgesehen, dass, wenn die Aufnahmeempfindlichkeit kleiner ist (einen kleineren ISO-Wert aufweist) als die Zielempfindlichkeit (der Belichtungskorrekturwert also negativ ist), als Rauschkorrektur für jeden Bildsignalwert der aufgezeichneten Bilddaten ein jeweiliger Rauschwert ermittelt wird und die korrigierten Bilddaten erzeugt werden, indem zu jedem Bildsignalwert der jeweilige Rauschwert hinzugefügt wird (wobei sich das Erzeugen der korrigierten Bilddaten nicht unbedingt darauf beschränken muss, sondern noch weitere Modifikationen der aufgezeichneten Bilddaten umfassen kann).

Die Rauschkorrektur kann insofern einem Datensatz von Rauschwerten entsprechen, der hinsichtlich seiner Auflösung, d. h. der Anzahl von in Zeilen und Spalten angeordneten Einzelwerten, einem jeweiligen mittels der Kamera aufgezeichneten Einzelbild entspricht, das von den während einer jeweiligen Einzelbelichtung erzeugten Bildsignalwerten gebildet wird. Somit lässt sich für ein jeweiliges Einzelbild jedem Bildsignalwert des Einzelbildes ein jeweiliger Rauschwert zuordnen, der für das Erzeugen der korrigierten Bilddaten dem jeweiligen Bildsignalwert hinzugefügt wird. Dieses Hinzufügen kann insbesondere einer einfachen Addition des jeweiligen Bildsignalwerts und des jeweiligen Rauschwerts entsprechen. Dabei kann für zumindest einen oder einige Bildsignalwerte der jeweilige Rauschwert auch null sein; es muss also nicht unbedingt jeder Bildsignalwert modifiziert werden.

Wenn die Aufnahmeempfindlichkeit kleiner ist als die Zielempfindlichkeit, weisen die bei der Aufnahmeempfindlichkeit aufgezeichneten Bilddaten im Vergleich zu einer Aufzeichnung bei der Zielempfindlichkeit ein reduziertes Rauschen auf. Durch das Hinzufügen der genannten Rauschwerte werden die aufgezeichneten Bilddaten mit einem zusätzlichen Rauschen zu versehen, so dass auf diese Weise das reduzierte Rauschen ausgeglichen werden kann.

Grundsätzlich kann das erfindungsgemäße Verfahren auch darauf beschränkt sein, dass die Aufnahmeempfindlichkeit kleiner ist als die Zielempfindlichkeit, so dass also stets als Rauschkorrektur für jeden Bildsignalwert der aufgezeichneten Bilddaten ein jeweiliger Rauschwert ermittelt wird und die korrigierten Bilddaten erzeugt werden, indem zu jedem Bildsignalwert der jeweilige Rauschwert hinzugefügt wird.

Gemäß einer weiteren vorteilhaften Ausführungsform ist vorgesehen, dass, wenn die Aufnahmeempfindlichkeit größer ist (einen größeren ISO-Wert aufweist) als die Zielempfindlichkeit (der Belichtungskorrekturwert also positiv ist), als Rauschkorrektur ein Rauschfilter ermittelt wird und die korrigierten Bilddaten erzeugt werden, indem die aufgezeichneten Bilddaten mittels des Rauschfilters gefiltert werden (wobei sich das Erzeugen der korrigierten Bilddaten nicht unbedingt darauf beschränken muss, sondern noch weitere Modifikationen der aufgezeichneten Bilddaten umfassen kann).

Aufgrund der Abhängigkeit von der Zielempfindlichkeit und/oder dem Belichtungskorrekturwert (bzw. der Aufnahmeempfindlichkeit) kann der Rauschfilter speziell dazu angepasst sein, für die jeweilige Empfindlichkeit charakteristische Rauschanteile auszufiltern. Dabei können für das Filtern grundsätzlich bekannte Verfahren der Rauschunterdrückung verwendet werden, wobei die Filterparameter konkret im Hinblick auf die Zielempfindlichkeit und/oder den Belichtungskorrekturwert (bzw. die Aufnahmeempfindlichkeit) gewählt werden. Die Filterparameter können dabei beispielsweise rechnerisch oder anhand einer Nachschlagetabelle in Abhängigkeit von der Zielempfindlichkeit und/oder dem Belichtungskorrekturwert (bzw. der Aufnahmeempfindlichkeit) ermittelt werden.

Wenn die Aufnahmeempfindlichkeit größer ist als die Zielempfindlichkeit, weisen die bei der Aufnahmeempfindlichkeit aufgezeichneten Bilddaten im Vergleich zu einer Aufzeichnung bei der Zielempfindlichkeit ein erhöhtes Rauschen auf. Durch das Filtern mittels des Rauschfilters wird das Rauschen in den aufgezeichneten Bilddaten reduziert, so dass auf diese Weise das erhöhte Rauschen ausgeglichen werden kann.

Grundsätzlich kann das erfindungsgemäße Verfahren auch darauf beschränkt sein, dass die Aufnahmeempfindlichkeit größer ist als die Zielempfindlichkeit, so dass also stets als Rauschkorrektur ein Rauschfilter ermittelt wird und die korrigierten Bilddaten erzeugt werden, indem die aufgezeichneten Bilddaten mittels des Rauschfilters gefiltert werden.

Gemäß einer weiteren vorteilhaften Ausführungsform wird die Rauschkorrektur anhand einer Rauschcharakteristik des Bildsensors ermittelt. Diese Rauschcharakteristik kann grundsätzlich modellgenerisch, d. h. für alle baugleichen Bildsensoren eines bestimmten Bildsensormodells gleich definiert sein. Vorzugsweise ist die Rauschcharakteristik jedoch exemplarspezifisch, d. h. für das konkrete in der Kamera verwendete Exemplar eines Bildsensors individuell definiert. Das Verfahren kann umfassen, dass die Rauschcharakteristik zunächst bestimmt wird, insbesondere im Rahmen von Kalibrationsschritten, die den genannten Verfahrensschritten vorgelagert sind. Das Bestimmen der Rauschcharakteristik erfolgt dabei vorzugweise empirisch. Nach dem Bestimmen der Rauschcharakteristik kann sie bzw. können Daten, die die Rauschcharakteristik definieren, beispielsweise in einem Speicher der Kamera gespeichert werden, aus dem sie für das Ermitteln der Rauschkorrektur dann ausgelesen werden kann/können.

Gemäß einer vorteilhaften Weiterbildung umfasst die Rauschcharakteristik ein theoretisches, insbesondere mathematisches, Modell für das Rauschen des Bildsensors. Das Ermitteln der Rauschkorrektur umfasst dann, dass mittels des Modells Daten zur Rauschkorrektur berechnet werden. Bei den berechneten Daten kann es sich insbesondere um die genannten Rauschwerte handeln.

Gemäß einer anderen vorteilhaften Weiterbildung umfasst die Rauschcharakteristik eine Nachschlagetabelle (auch als Look-up-Tabelle bezeichnet). Mit anderen Worten können die Rauschcharakteristik oder zumindest Teile der in die Rauschcharakteristik einfließenden Information in einer Nachschlagetabelle hinterlegt sein. Das Ermitteln der Rauschkorrektur umfasst dann, dass Daten zur Rauschkorrektur aus der Nachschlagetabelle ausgelesen werden. Bei den aus der Nachschlagetabelle ausgelesenen Daten kann es sich insbesondere um die genannten Rauschwerte handeln oder um Daten, aus denen sich diese Rauschwerte ableiten lassen.

Die genannte Nachschlagetabelle kann beispielweise für jedes Detektorelement des Bildsensors eine Standardabweichung enthalten. Die Standardabweichungen können durch temporale Messungen ermittelt worden sein. Das kann insbesondere umfassen, dass über einen bestimmten Zeitraum unter definierten Bedingungen, beispielsweise bei zumindest im Wesentlichen einheitlicher Beleuchtung des Bildsensors, Bildsignalwerte erfasst werden und für jedes Detektorelement die Standardabweichung aller während dieses Zeitraums an dem jeweiligen Detektorelement erzeugten Bildsignalwerte ermittelt wird. Die Rauschwerte können dann basierend auf diesen Standardabweichungen ermittelt werden. Dabei kann die Nachschlagetabelle für verschiedene Zielempfindlichkeiten und/oder Belichtungskorrekturwerte (bzw. Aufnahmeempfindlichkeiten) verschiedene Standardabweichungen enthalten. Die Zielempfindlichkeit und/oder der Belichtungskorrekturwert (bzw. die Aufnahmeempfindlichkeit) kann/können aber auch (erst) in das Ermitteln der Rauschwerte anhand der Standardabweichungen einfließen.

Sofern die Rauschcharakteristik sowohl das genannte theoretische Modell für das Rauschen des Bildsensors als auch die genannte Nachschlagetabelle umfasst, können in der Nachschlagetabelle als Daten auch Parameter, insbesondere für verschiedene Zielempfindlichkeiten und/oder Belichtungskorrekturwerte (bzw. Aufnahmeempfindlichkeiten) verschiedene Parameter, des Modells hinterlegt sein, die dann aus der Nachschlagetabelle ausgelesen werden können. Anschließend können mittels des auf diese Weise, insbesondere in Abhängigkeit von der Zielempfindlichkeit und/oder dem Belichtungskorrekturwert (bzw. der Aufnahmeempfindlichkeit), parametrierten Modells zum Beispiel die genannten Rauschwerte oder eine sonstige Rauschkorrektur berechnet werden.

Grundsätzlich können die korrigierten Bilddaten außerhalb der Kamera erzeugt werden, d.h. der Schritt des Korrigierens der Bilddaten anhand der Rauschkorrektur kann bei einigen Ausführungsformen auch außerhalb der Kamera durchgeführt werden. Beispielsweise können die aufgezeichneten Bilddaten von der Kamera ausgegeben werden und dann mittels einer kameraexternen Vorrichtung anhand der Rauschkorrektur modifiziert werden, zum Beispiel mittels einer separaten Bildverarbeitungseinheit (insbesondere lokal oder entfernt) oder mittels einer entfernten verteilten Bildverarbeitungseinrichtung (insbesondere Rechenzentrum und/oder "Cloud"-Server). Der Schritt des Korrigierens der Bilddaten anhand der Rauschkorrektur kann insbesondere auch zeitlich unabhängig von dem Schritt des Aufzeichnens der Bilddaten mittels der Kamera durchgeführt werden, ohne dass dies im unmittelbaren Anschluss geschehen muss.

Gemäß einer vorteilhaften Ausführungsform erfolgt das Erzeugen der korrigierten Bilddaten in der Kamera, vorzugsweise unmittelbar im Anschluss an das Aufzeichnen der Bilddaten und gegebenenfalls fortlaufend während des Aufzeichnens weiterer Bilddaten. Wenn die korrigierten Bilddaten in der Kamera erzeugt werden, kann die Kamera sie anschließend ausgeben. Insbesondere kann vorgesehen sein, dass die Kamera die Bilddaten stets in bereits korrigierter Form ausgibt, sei es zusammen mit den aufgezeichneten (noch nicht korrigierten) Bilddaten oder ausschließlich die korrigierten Bilddaten.

Für das Erzeugen der korrigierten Bilddaten kann die Kamera eine Bildverarbeitungseinheit umfassen, die dazu ausgebildet ist, die korrigierten Bilddaten zu erzeugen. Ferner kann auch das Ermitteln der Rauschkorrektur in der Kamera erfolgen, wozu die Bildverarbeitungseinheit (sofern vorgesehen) außerdem dazu ausgebildet sein, die Rauschkorrektur zu ermitteln. Darüber hinaus ist es vorteilhaft, wenn auch die Aufnahmeempfindlichkeit und die Zielempfindlichkeit an der Kamera vorgegeben werden können, wozu die Kamera eine Eingabevorrichtung aufweisen kann. Auf diese Weise brauchen für die Durchführung des Verfahrens weder eine kameraexterne Vorrichtung noch Zubehör für die Kamera vorgesehen zu werden. Die Bildverarbeitungseinheit kann Teil einer Steuervorrichtung der Kamera sein, mit der die Eingabevorrichtung (sofern vorgesehen) verbunden sein kann.

Gemäß einer weiteren vorteilhaften Ausführungsform umfasst das Verfahren ferner: dass zunächst bei gegebenen (d. h. bei den aufgrund äußerer Umstände und/oder jeweiliger Einstellungen, insbesondere der Beleuchtung, der Blende und/oder des Verschlusses, aktuell herrschenden) Belichtungsverhältnissen mittels der Kamera Referenzbilddaten aufgezeichnet werden, während die Empfindlichkeit des Bildsensors auf die Zielempfindlichkeit eingestellt ist; und dass nach einer Änderung der Belichtungsverhältnisse in Abhängigkeit von der Änderung der Belichtungsverhältnisse der Belichtungskorrekturwert ermittelt wird. Der Belichtungskorrekturwert kann dabei direkt ermittelt werden oder aber indirekt, indem in Abhängigkeit von der Änderung der Belichtungsverhältnisse die neue Aufnahmeempfindlichkeit ermittelt wird, der deren Abweichung von der Zielempfindlichkeit dem Belichtungskorrekturwert entspricht.

Mit anderen Worten wird vor den vorstehend genannten Verfahrensschritten, zumindest vor dem Vorgeben der Aufnahmeempfindlichkeit, die Aufnahmeempfindlichkeit (direkt oder indirekt über den Belichtungskorrekturwert) zunächst ermittelt und zwar basierend auf einer Änderung der Belichtungsverhältnisse, die eingetreten ist, nachdem zuvor Bilddaten aufgezeichnet worden sind, die hier (vor allem zur begrifflichen Unterscheidung von den im Rahmen des weiteren Verfahrens aufgezeichneten Bilddaten) als Referenzbilddaten bezeichnet werden. Die Belichtungsverhältnisse werden dabei insbesondere durch die Helligkeit bzw. Beleuchtung der aufgezeichneten Szene, durch die eingestellte Apertur einer Blende der Kamera und/oder durch die eingestellte Verschlusszeit eines Verschlusses der Kamera definiert und können sich insofern insbesondere aufgrund einer Änderung der Helligkeit/Beleuchtung, der Apertur und/oder der Verschlusszeit ändern. Als Belichtungskorrekturwert kann dabei insbesondere ermittelt werden, in welchem Maße die Empfindlichkeit des Bildsensor aufgrund der Änderung der Belichtungsverhältnisse verändert werden muss, um Bilddaten aufzuzeichnen, deren Helligkeit zumindest im Wesentlichen derjenigen der Referenzbilddaten entspricht.

Die Aufgabe der Erfindung wird auch durch ein Verfahren zum Modifizieren von Bilddaten gelöst, das die folgenden Schritte umfasst:
- Empfangen von Bilddaten einer Kamera, insbesondere einer Bewegtbildkamera, die einer eingestellten Aufnahmeempfindlichkeit entsprechen;
- Empfangen der eingestellten Aufnahmeempfindlichkeit;
- Empfangen einer Zielempfindlichkeit;
- Ermitteln einer Rauschkorrektur in Abhängigkeit von der Aufnahmeempfindlichkeit und der Zielempfindlichkeit; und
- Modifizieren der empfangenen Bilddaten anhand der Rauschkorrektur.

Die Bilddaten können insbesondere mit einer eingestellten Aufnahmeempfindlichkeit aufgezeichnet und/oder von einem Bildsensor mit verstellbarer Empfindlichkeit erzeugt worden sein, wie vorstehend erläutert. Die eingestellte Aufnahmeempfindlichkeit kann bei einigen Ausführungsformen separat von den Bilddaten empfangen werden, oder die eingestellte Aufnahmeempfindlichkeit kann in die Bilddaten eingebettet sein (insbesondere als Metadaten) und zusammen mit den Bilddaten empfangen werden. Die Zielempfindlichkeit kann bei einigen Ausführungsformen durch Benutzereingabe empfangen werden. Ferner kann die Rauschkorrektur bei einigen Ausführungsformen indirekt über einen Belichtungskorrekturwert ermittelt werden, der eine Abweichung der Aufnahmeempfindlichkeit von der Zielempfindlichkeit repräsentiert, d.h. der Rauschwert kann auch in Abhängigkeit von einem derartigen Belichtungskorrekturwert ermittelt werden, wie vorstehend erläutert.

Das Verfahren ermöglicht das Nachbilden eines Bildeindrucks, der einer anderen als der beim Aufzeichnen der Bilddaten tatsächlich eingestellten Aufnahmeempfindlichkeit entspricht, nämlich einer auswählbaren Zielempfindlichkeit. Zugleich gestattet das Verfahren ein reproduzierbares Modifizieren der Bilddaten, d.h. das wahrgenommene Bildrauschen entspricht stets und in gleichem Maße der jeweiligen (tatsächlichen oder virtuellen) Empfindlichkeit (eingestellte Aufnahmeempfindlichkeit oder ausgewählte Zielempfindlichkeit). Dies ist insbesondere bei Bewegtbildaufnahmen wichtig, beispielsweise wenn im Filmschnitt mehrere Bewegtbildaufnahmen zu einer einzigen Sequenz zusammengesetzt werden.

Die Aufgabe der Erfindung wird auch gelöst durch eine Kamera, insbesondere eine Bewegtbildkamera, die umfasst: einen Bildsensor mit verstellbarer Empfindlichkeit, der eine Vielzahl von in Zeilen und Spalten angeordneten lichtempfindlichen Detektorelementen umfasst und dazu ausgebildet ist, in Abhängigkeit von der Intensität von Licht, das während einer jeweiligen Einzelbelichtung auf ein jeweiliges Detektorelement auftrifft, eine jeweilige elektrische Ladung zu erzeugen und sie in Abhängigkeit von der eingestellten Empfindlichkeit zu verstärken und in einen jeweiligen Bildsignalwert umzuwandeln; und eine Steuervorrichtung, die dazu ausgebildet ist, die Kamera zum Aufzeichnen von Bilddaten gemäß dem erfindungsgemäßen Verfahren, insbesondere gemäß einer der vorstehend beschriebenen Ausführungsformen des Verfahrens, anzusteuern.

Außerdem kann die Steuervorrichtung dazu ausgebildet sein, die Rauschkorrektur zu ermitteln und/oder die korrigierten Bilddaten zu erzeugen. Sofern die Kamera eine gesonderte Bildverarbeitungseinheit umfasst, kann das auch dadurch erfolgen, dass die Steuervorrichtung die Bildverarbeitungseinheit dazu ansteuert, die Rauschkorrektur zu ermitteln bzw. die korrigierten Bilddaten zu erzeugen. Die Bildverarbeitungseinheit kann aber auch in die Steuervorrichtung integriert sein.

Die im Zusammenhang mit der Erfindung jeweils genannte Steuervorrichtung und/oder Bildverarbeitungseinheit kann beispielsweise einen integrierten Schaltkreis (IC), einen Mikroprozessor, eine zentrale Recheneinheit (CPU), eine Grafikprozessoreinheit (GPU), eine Anwendungsspezifische Integrierte Schaltung (ASIC) und/oder ein Field Programmable Gate Array (FPGA) umfassen oder zumindest im Wesentlichen dadurch gebildet sein.

Des Weiteren kann die Kamera eine (insbesondere die weiter oben bereits erwähnte) Eingabevorrichtung umfassen, mittels deren die Aufnahmeempfindlichkeit, die Zielempfindlichkeit und/oder der Belichtungskorrekturwert vorgegeben werden können. Die Steuervorrichtung kann dann die Aufnahmeempfindlichkeit, die Zielempfindlichkeit und/oder den Belichtungskorrekturwert von der Eingabevorrichtung empfangen und darauf basierend die Kamera zum Aufzeichnen ansteuern, die Rauschkorrektur ermitteln und die korrigierten Bilddaten erzeugen.

Gemäß einer vorteilhaften Ausführungsform umfasst die Kamera ferner einen Speicher, in dem eine Rauschcharakteristik des Bildsensors gespeichert ist, wobei die Steuervorrichtung dazu ausgebildet ist, die Rauschcharakteristik aus dem Speicher auszulesen und die Rauschkorrektur anhand der ausgelesenen Rauschcharakteristik zu ermitteln. Dass die Rauschcharakteristik in dem Speicher gespeichert ist, kann dabei bedeuten, dass zumindest Daten, die für die Rauschcharakteristik des Bildsensors maßgeblich sind, in dem Speicher gespeichert sind.

Die Kamera kann ferner auf eine der vorstehend im Zusammenhang mit dem erfindungsgemäßen Verfahren beschriebenen Weisen ausgebildet sein. Für das Verfahren beschriebene Ausführungsformen und deren Vorteile gelten in entsprechender Weise auch für die Kamera.

Die Erfindung wird im Folgenden lediglich beispielhaft unter Bezugnahme auf die Figuren weiter erläutert.
- Fig. 1: zeigt eine Ausführungsform einer erfindungsgemäßen Kamera in vereinfachter schematischer Darstellung.
- Fig. 2: veranschaulicht in schematischer Darstellung den Ablauf einer Ausführungsform des erfindungsgemäßen Verfahrens.

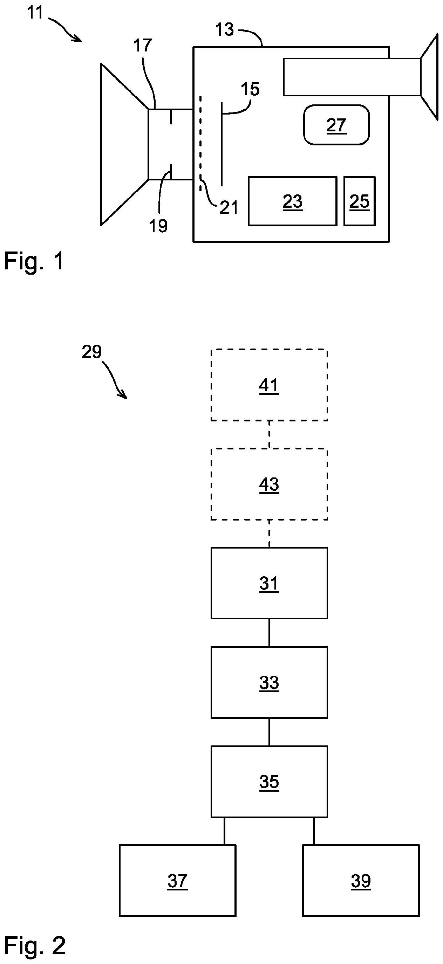

Die in Fig. 1 gezeigte Kamera 11, bei der es sich um eine Bewegtbildkamera handelt, umfasst ein Kameragehäuse 13, in dem ein Bildsensor 15 der Kamera 11 angeordnet ist, sowie ein an dem Kameragehäuse 13 angebrachtes Objektiv 17. Das Objektiv 17 ist dazu ausgebildet, Licht einer aufzuzeichnenden Szene (nicht dargestellt) auf den Bildsensor 15 abzubilden.

Der Bildsensor 15 umfasst eine Vielzahl von in Zeilen und Spalten angeordneten lichtempfindlichen Detektorelementen und ist dazu ausgebildet, in Abhängigkeit von der Intensität des Lichts, dass während einer jeweiligen Einzelbelichtung durch das Objektiv 17 dringt und auf ein jeweiliges der Detektorelemente auftrifft, eine jeweilige elektrische Ladung zu erzeugen. Dabei weist der Bildsensor 15 eine verstellbare Empfindlichkeit auf und ist dazu ausgebildet, die jeweilige elektrische Ladung in Abhängigkeit von der eingestellten Empfindlichkeit zu verstärken und in einen jeweiligen Bildsignalwert umzuwandeln. Die während einer jeweiligen Einzelbelichtung auf diese Weise erzeugten Bildsignalwerte bilden dann gemeinsam ein jeweiliges Einzelbild. Als Bewegtbildkamera ist die Kamera 11 dazu ausgebildet, mit konstanter, vorzugweise einstellbarer, Bildrate durch eine Vielzahl schnell aufeinanderfolgender Einzelbelichtungen eine Abfolge mehrerer Einzelbilder aufzuzeichnen. Bei den Bilddaten, zu deren Aufzeichnen die Kamera 11 ausgebildet ist, werden insofern durch diese Einzelbilder gebildet.

Die Kamera 11 umfasst ferner eine Blende 19, die grundsätzlich in das Objektiv 17 integriert oder auch unabhängig davon sein kann. Die Blende 19 weist eine verstellbare Apertur auf, die den Querschnitt des durch das Objektiv 17 einfallenden Strahlenbündels beschränkt und durch die somit die Menge an Licht, die während einer jeweiligen Einzelbelichtung auf den Bildsensor 15 trifft, beeinflusst werden kann. Außerdem umfasst die Kamera 11 einen Verschluss 21, der schematisch durch eine unterbrochene Linie dargestellt ist. Der Verschluss 21 weist eine verstellbare Verschlusszeit auf, durch die die Dauer der jeweiligen Einzelbelichtung, während deren Licht auf den Bildsensor 15 trifft, bestimmt wird. Der Verschluss 21 kann durch ein mechanisches Element oder als elektronischer Verschluss verwirklicht sein. Beispielsweise kann der Verschluss 21 in Form einer Umlaufblende ausgebildet sein.

Darüber hinaus umfasst die Kamera 11 eine Steuervorrichtung 23, einen Speicher 25, in dem eine, insbesondere empirisch für den jeweiligen Bildsensor 15 ermittelte, Rauschcharakteristik gespeichert ist, die von der Steuervorrichtung 23 ausgelesen werden kann, sowie eine Eingabevorrichtung 27, über die die Steuervorrichtung 23 Nutzereingaben empfangen kann. Die Steuervorrichtung 21 ist dazu ausgebildet, die Empfindlichkeit des Bildsensors 15, die Apertur der Blende 19 sowie die Verschlusszeit des Verschlusses 21 einzustellen und allgemein die Kamera 11 dazu anzusteuern, gemäß den vorgenommenen Einstellungen Bilddaten aufzuzeichnen. Insbesondere ist die Steuervorrichtung 21 dazu ausgebildet, die Kamera 11 zum Aufzeichnen von Bilddaten gemäß dem in Fig. 2 veranschaulichten Verfahren 29 anzusteuern.

Das Verfahren 29 umfasst als Verfahrensschritt 31, dass eine Aufnahmeempfindlichkeit und eine Zielempfindlichkeit vorgegeben werden, wobei die Aufnahmeempfindlichkeit um einen Belichtungskorrekturwert von der Zielempfindlichkeit abweicht. Die Aufnahmeempfindlichkeit, die Zielempfindlichkeit und/oder der Belichtungskorrekturwert können insbesondere über die Eingabevorrichtung 27 eingegeben werden. Das ist jedoch nicht zwingend erforderlich, da sie auch auf andere Weise vorgegeben werden können. Beispielsweise kann die Zielempfindlichkeit vorab festgelegt sein und der Belichtungskorrekturwert im Rahmen des Verfahrens 29 zuvor ermittelt werden (wie weiter unten noch erläutert wird), wodurch diese beiden Werte dann im Verfahrensschritt 31 vorgegeben werden.

Das Verfahren 29 umfasst ferner als Verfahrensschritt 33, dass mittels der Kamera 11 Bilddaten aufgezeichnet werden, während die Empfindlichkeit des Bildsensors 15 auf die Aufnahmeempfindlichkeit eingestellt ist. Es kann insbesondere eine Abfolge von Einzelbildern aufgezeichnet werden, indem mehrere Einzelbelichtungen schnell aufeinanderfolgen und in jeder Einzelbelichtung eine von der Apertur der Blende 19 und von der Verschlusszeit des Verschlusses 21 abhängige Menge an Licht auf die Detektorelemente des Bildsensors 15 trifft und über infolgedessen erzeugte elektrische Ladungen in Bildsignalwerte umgewandelt wird, die dann das jeweilige Einzelbild bilden.

In einem weiteren Verfahrensschritt 35 wird die Aufnahmeempfindlichkeit mit der Zielempfindlichkeit verglichen (bzw. das Vorzeichen des Belichtungskorrekturwerts ausgewertet). Wenn die Aufnahmeempfindlichkeit kleiner als die Zielempfindlichkeit ist (negativer Belichtungskorrekturwert), wird das Verfahren mit dem Verfahrensschritt 37 fortgesetzt; andernfalls wird das Verfahren mit dem Verfahrensschritt 39 fortgesetzt. In beiden Verfahrensschritten 37, 39 wird dabei jeweils in Abhängigkeit von der Zielempfindlichkeit und/oder dem Belichtungskorrekturwert eine Rauschkorrektur ermittelt, wobei das jeweils umfasst, dass die genannte Rauschcharakteristik aus dem Speicher 25 ausgelesen wird und anhand der ausgelesenen Rauschcharakteristik die Rauschkorrektur ermittelt wird. Beispielsweise kann die Rauschcharakteristik zumindest teilweise in Form einer Nachschlagetabelle in dem Speicher 25 gespeichert sein, die für verschiedene Kombinationen von Zielempfindlichkeit und Belichtungskorrekturwert (oder von Aufnahmeempfindlichkeit und Belichtungskorrekturwert oder von Aufnahmeempfindlichkeit und Zielempfindlichkeit) verschiedene Daten zur Rauschkorrektur umfasst.

Im Verfahrensschritt 37 können aus der Nachschlagetabelle zum Beispiel jeweilige Modellparameter ausgelesen werden, mit denen dann ein von der Rauschcharakteristik ebenfalls umfasstes Modell des Rauschens des Bildsensors 15 parametriert werden kann. Mittels dieses Modells kann dann (weiterhin im Verfahrensschritt 37) für jeden Bildsignalwert der aufgezeichneten Bilddaten ein jeweiliger Rauschwert berechnet werden, der zu dem jeweiligen Bildsignalwert addiert wird, um auf diese Weise korrigierte Bilddaten zu erhalten.

Im Verfahrensschritt 39 können aus der Nachschlagetabelle zum Beispiel jeweilige Filterparameter ausgelesen werden, mit denen dann ein von der Rauschcharakteristik ebenfalls umfasster Rauschfilter parametriert und auf diese Weise ermittelt wird. Mittels dieses Rauschfilters können die aufgezeichneten Bilddaten dann (weiterhin im Verfahrensschritt 39) gefiltert werden, um auf diese Weise korrigierte Bilddaten zu erhalten.

In beiden Fällen sind die korrigierten Bilddaten letztlich im Hinblick auf das darin enthaltene Rauschen an die vorgegebene Zielempfindlichkeit und deren Unterschied zur Aufnahmeempfindlichkeit angepasst. Eine solche Anpassung ist vor allem dann sinnvoll, wenn die aufgezeichneten Bilddaten zu zuvor bei anderen Belichtungsverhältnissen aufgezeichneten Bilddaten, die zur Unterscheidung im Folgenden als Referenzbilddaten bezeichnet werden, insofern "passen" sollen, als nicht erkennbar sein soll, dass die Bilddaten und die Referenzbilddaten bei unterschiedlichen Belichtungsverhältnissen aufgezeichnet worden sind.

Das Verfahren 29 kann dabei auch das Aufzeichnen der Referenzbilddaten umfassen, nämlich wenn es die weiteren Verfahrensschritte 41, 43 umfasst, die den genannten Verfahrensschritten 31-39 vorgelagert sind (in Fig. 2 mit unterbrochener Linie dargestellt). Im Verfahrensschritt 41 werden bei gegebenen (d. h. bei den zum jeweiligen Zeitpunkt des Aufzeichnens aufgrund äußerer Umstände und/oder jeweiliger Einstellungen herrschenden) Belichtungsverhältnissen mittels der Kamera 11 Referenzbilddaten aufgezeichnet, wobei die Empfindlichkeit des Bildsensors 15 für diese Aufzeichnung auf die Zielempfindlichkeit eingestellt ist, die zu diesem Zeitpunkt im Wesentlichen frei gemäß einer jeweiligen gestalterischen Intention gewählt sein kann.

Nach einer Änderung der Belichtungsverhältnisse, die sich aufgrund externer Umstände oder als (unerwünschter) Nebeneffekt eines, etwa aus kreativen Gründen erfolgten, Verstellens einer sich auf die Belichtungsverhältnisse auswirkenden Einstellung (beispielsweise der Blendenapertur) ergeben kann, wird dann im Verfahrensschritt 43 in Abhängigkeit von dieser Änderung der Belichtungsverhältnisse der Belichtungskorrekturwert ermittelt. Der Belichtungskorrekturwert wird dabei zweckmäßigerweise derart ermittelt, dass er angibt, um wie viel sich die Belichtung, insbesondere durch Verstellen der Empfindlichkeit des Bildsensors 15, ändern muss, damit unter den veränderten Belichtungsverhältnissen aufgezeichnete Bilddaten im Wesentlichen dieselbe Helligkeit aufweisen wie die Referenzbilddaten.

Anschließend kann aus der Zielempfindlichkeit und dem Belichtungskorrekturwert die Aufnahmeempfindlichkeit für das weitere Aufzeichnen von Bilddaten ermittelt und im Verfahrensschritt 31 zusammen mit der Zielempfindlichkeit für die weiteren Verfahrensschritte 33-39 vorgegeben werden. Die Aufnahmeempfindlichkeit braucht dabei nicht unbedingt explizit ermittelt und vorgegeben zu werden, da sie auch lediglich indirekt vorgegeben werden kann, indem im Verfahrensschritt 31 stattdessen die Zielempfindlichkeit und der ermittelte Belichtungskorrekturwert vorgegeben werden.

### Bezugszeichen

- 11: Kamera
- 13: Kameragehäuse
- 15: Bildsensor
- 17: Objektiv
- 19: Blende
- 21: Verschluss
- 23: Steuervorrichtung
- 25: Speicher
- 27: Eingabevorrichtung
- 29: Verfahren
- 31-43: Verfahrensschritte

## Patentansprüche

1. Verfahren zum Aufzeichnen von Bilddaten mittels einer Kamera (11), insbesondere mittels einer Bewegtbildkamera,
wobei die Kamera (11) einen Bildsensor (15) mit verstellbarer Empfindlichkeit umfasst, der eine Vielzahl von in Zeilen und Spalten angeordneten lichtempfindlichen Detektorelementen umfasst und dazu ausgebildet ist, in Abhängigkeit von der Intensität von Licht, das während einer jeweiligen Einzelbelichtung auf ein jeweiliges Detektorelement auftrifft, eine jeweilige elektrische Ladung zu erzeugen und sie in Abhängigkeit von der eingestellten Empfindlichkeit zu verstärken und in einen jeweiligen Bildsignalwert umzuwandeln,
wobei das Verfahren (29) umfasst:
- dass eine Aufnahmeempfindlichkeit und eine Zielempfindlichkeit vorgegeben werden (31), wobei die Aufnahmeempfindlichkeit um einen Belichtungskorrekturwert von der Zielempfindlichkeit abweicht;
- dass mittels der Kamera (11) Bilddaten aufgezeichnet werden (33), während die Empfindlichkeit des Bildsensors (15) auf die Aufnahmeempfindlichkeit eingestellt ist;
- dass in Abhängigkeit von der Zielempfindlichkeit und/oder dem Belichtungskorrekturwert eine Rauschkorrektur ermittelt wird (35); und
- dass korrigierte Bilddaten erzeugt werden (37, 39), indem die aufgezeichneten Bilddaten anhand der Rauschkorrektur modifiziert werden.

2. Verfahren nach Anspruch 1,
wobei, wenn die Aufnahmeempfindlichkeit kleiner ist als die Zielempfindlichkeit, als Rauschkorrektur für jeden Bildsignalwert der aufgezeichneten Bilddaten ein jeweiliger Rauschwert ermittelt wird und die korrigierten Bilddaten erzeugt werden (37), indem zu jedem Bildsignalwert der jeweilige Rauschwert hinzugefügt wird.

3. Verfahren nach Anspruch 1 oder 2,
wobei, wenn die Aufnahmeempfindlichkeit größer ist als die Zielempfindlichkeit, als Rauschkorrektur ein Rauschfilter ermittelt wird und die korrigierten Bilddaten erzeugt werden (39), indem die aufgezeichneten Bilddaten mittels des Rauschfilters gefiltert werden.

4. Verfahren nach einem der vorstehenden Ansprüche,
wobei die Rauschkorrektur anhand einer Rauschcharakteristik des Bildsensors (15) ermittelt wird.

5. Verfahren nach Anspruch 4,
wobei die Rauschcharakteristik ein theoretisches Modell für das Rauschen des Bildsensors (15) umfasst und das Ermitteln der Rauschkorrektur umfasst, dass mittels des Modells Daten zur Rauschkorrektur berechnet werden.

6. Verfahren nach Anspruch 4 oder 5,
wobei die Rauschcharakteristik eine Nachschlagetabelle umfasst und das Ermitteln der Rauschkorrektur umfasst, dass Daten zur Rauschkorrektur aus der Nachschlagetabelle ausgelesen werden.

7. Verfahren nach einem der vorstehenden Ansprüche,
wobei die Aufnahmeempfindlichkeit und die Zielempfindlichkeit durch einen Nutzer der Kamera (11) direkt oder indirekt vorgegeben werden.

8. Verfahren nach einem der vorstehenden Ansprüche,
wobei das Erzeugen der korrigierten Bilddaten in der Kamera (11) erfolgt.

9. Verfahren nach einem der vorstehenden Ansprüche,
wobei das Verfahren (29) ferner umfasst:
- dass zunächst bei gegebenen Belichtungsverhältnissen mittels der Kamera (11) Referenzbilddaten aufgezeichnet werden (41), während die Empfindlichkeit des Bildsensors (15) auf die Zielempfindlichkeit eingestellt ist; und
- dass nach einer Änderung der Belichtungsverhältnisse in Abhängigkeit von der Änderung der Belichtungsverhältnisse der Belichtungskorrekturwert ermittelt wird (43).

10. Kamera (11), insbesondere Bewegtbildkamera, umfassend:
- einen Bildsensor (15) mit verstellbarer Empfindlichkeit, der eine Vielzahl von in Zeilen und Spalten angeordneten lichtempfindlichen Detektorelementen umfasst und dazu ausgebildet ist, in Abhängigkeit von der Intensität von Licht, das während einer jeweiligen Einzelbelichtung auf ein jeweiliges Detektorelement auftrifft, eine jeweilige elektrische Ladung zu erzeugen und sie in Abhängigkeit von der eingestellten Empfindlichkeit zu verstärken und in einen jeweiligen Bildsignalwert umzuwandeln; und
- eine Steuervorrichtung (23), die dazu ausgebildet ist, die Kamera (11) zum Aufzeichnen von Bilddaten gemäß einem Verfahren (29) nach einem der vorstehenden Ansprüche anzusteuern.

11. Kamera nach Anspruch 10,
wobei die Kamera (11) ferner umfasst:
- einen Speicher (25), in dem eine Rauschcharakteristik des Bildsensors (15) gespeichert ist; und
wobei die Steuervorrichtung (23) dazu ausgebildet ist, die Rauschcharakteristik aus dem Speicher (25) auszulesen und die Rauschkorrektur anhand der ausgelesenen Rauschcharakteristik zu ermitteln.

12. Kamera nach Anspruch 10 oder 11,
wobei die Kamera (11) ferner umfasst:
- eine Eingabevorrichtung (27), über welche die Aufnahmeempfindlichkeit, die Zielempfindlichkeit und/oder der Belichtungskorrekturwert vorgegeben werden können.
